# EUROPEAN PATENT APPLICATION

(11) **EP 4 734 156 A1**
(43) Date of publication of application: **29.04.2026**
(21) Application number: 25197279.0
(22) Date of filing: 21.08.2025
(51) Int. Cl.: H01L 23/498, H01L 21/48, H01L 23/13, H01L 23/15, H01L 21/764, H01L 21/768, H01L 21/683, H01L 23/538, H01L 25/18, H01L 23/00, H05K 1/18, H10B 80/00

(54) **METHODS AND APPARATUS TO MITIGATE CRACKING IN GLASS CORES**

(30) Priority: 25.10.2024 US 202418927201
(71) Applicant: INTEL Corporation, Santa Clara, CA 95054 (US)
(72) Inventor: RAMANUJA PIETAMBARAM, Srinivas Venkata, Chandler (US); MANEPALLI, Rahul, Chandler (US); KANDANUR, Sashi, Chandler, 85226 (US)
(74) Representative: Viering, Jentschura & Partner mbB Patent- und Rechtsanwälte

(57) **Abstract**

Methods and apparatus to mitigate cracking in glass cores are disclosed. An example apparatus comprises a glass core having an opening extending between opposing surfaces of the glass core, and a metal within the opening, a gap between an interface of the metal and a sidewall of the opening.

## Description

### BACKGROUND

In many electronic devices, integrated circuit (IC) chips and/or semiconductor dies are connected to larger circuit boards such as motherboards and/or other types of printed circuit boards (PCBs) via a package substrate. Some package substrates include a glass substrate (e.g., a glass core) having one or more vias extending between first and second sides of the glass substrate. Conductive material may be provided in the vias to electrically couple devices (e.g., the IC chips and/or semiconductor dies) to each other and/or to a PCB.

### BRIEF DESCRIPTION OF THE DRAWINGS

FIG. 1 illustrates an example integrated circuit (IC) package constructed in accordance with teachings disclosed herein.
FIG. 2A is an example first package substrate constructed in accordance with teachings disclosed herein.
FIG. 2B is an example second package substrate constructed in accordance with examples disclosed herein.
FIG. 3A is a detailed view of an example first interface that can be included in the first package substrate of FIG. 2A or the second package substrate of FIG. 2B.
FIG. 3B is a detailed view of an example second interface that can be included in the first package substrate of FIG. 2A or the second package substrate of FIG. 2B.
FIG. 3C is a detailed view of an example third interface that can be included in the first package substrate of FIG. 2A or the second package substrate of FIG. 2B.
FIG. 3D is a detailed view of an example fourth interface that can be included in the first package substrate of FIG. 2A or the second package substrate of FIG. 2B.
FIG. 4 is a flowchart representative of an example method of manufacturing the example first package substrate of FIG. 2A and/or the example second package substrate of FIG. 2B in accordance with example techniques described in connection with FIGS. 5A-6G.
FIGS. 5A-5G illustrate various stages in an example process of fabrication of the example first package substrate of FIG. 2A.

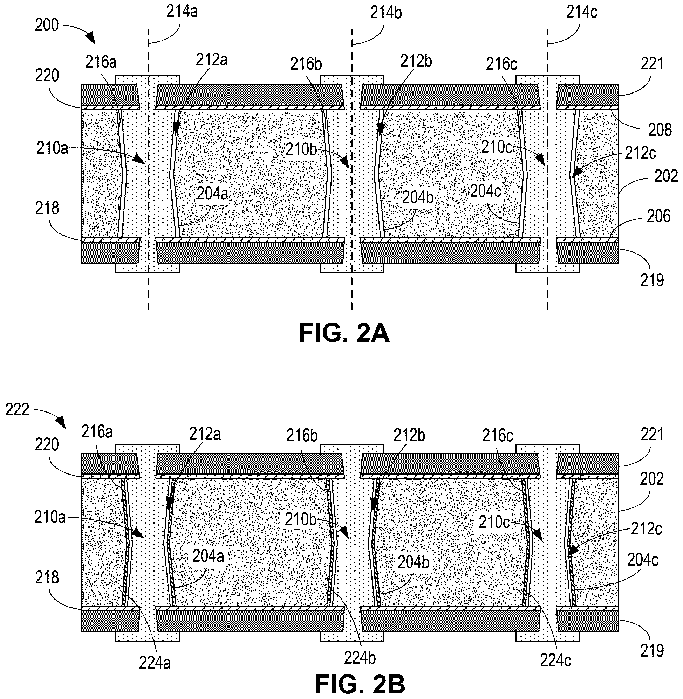

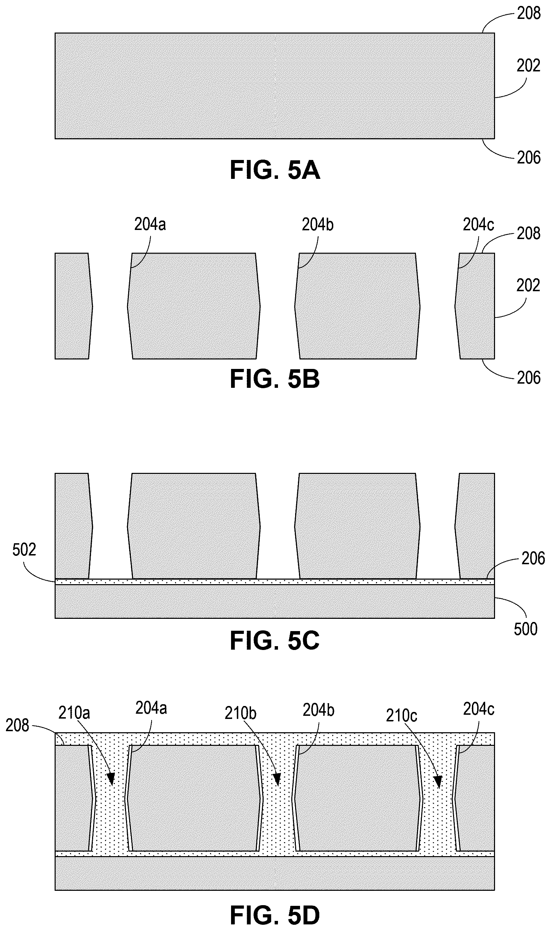

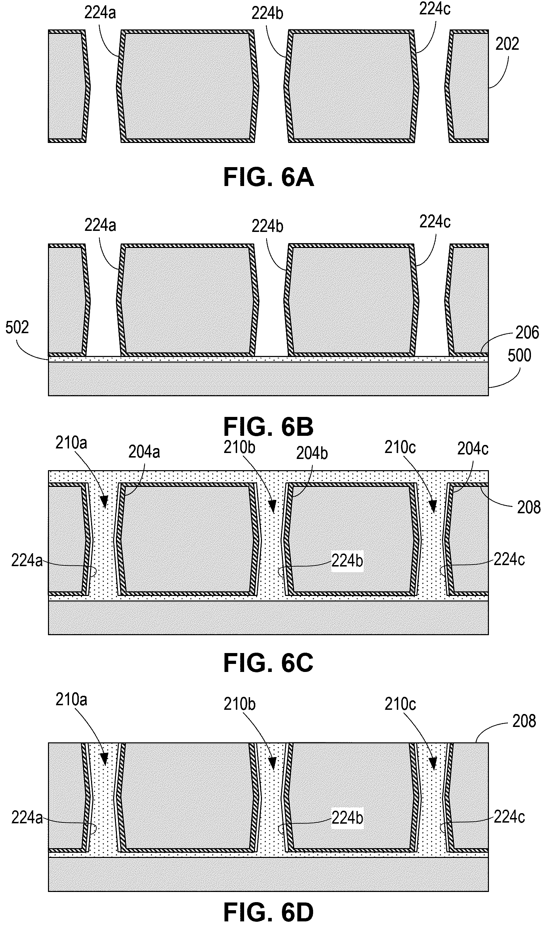

FIGS. 5A, 5B, and 6A-6G illustrate various stages in an example process of fabrication of the example second package substrate of FIG. 2B.

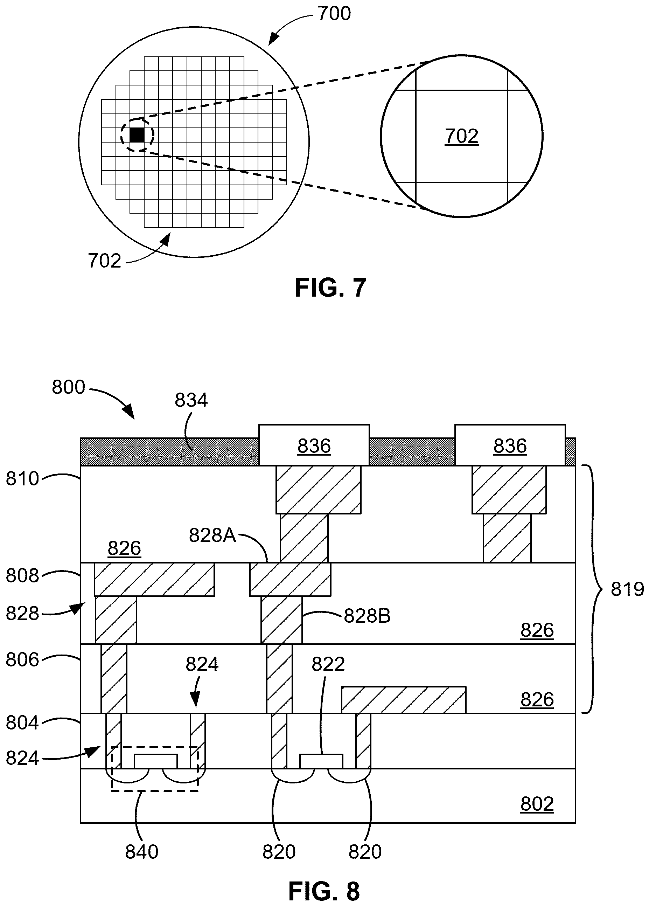

FIG. 7 is a top view of a wafer including dies that may be included in an IC package constructed in accordance with teachings disclosed herein.
FIG. 8 is a cross-sectional side view of an IC device that may be included in an IC package constructed in accordance with teachings disclosed herein.

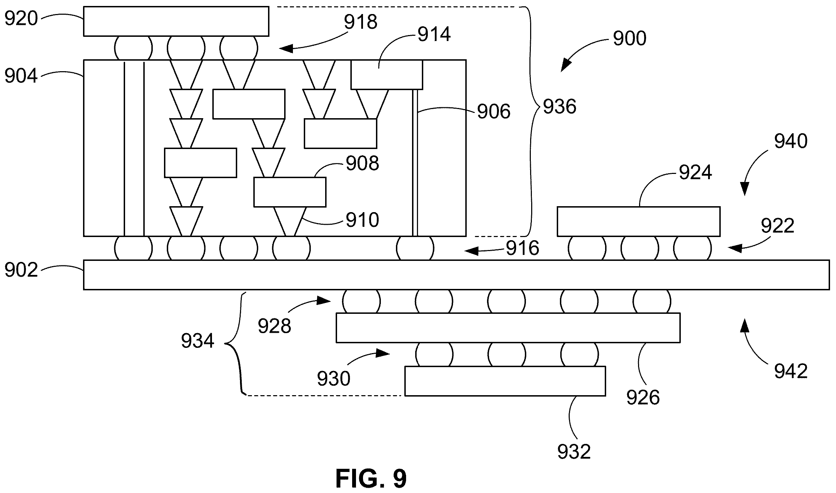

FIG. 9 is a cross-sectional side view of an IC device assembly that may include an IC package constructed in accordance with teachings disclosed herein.

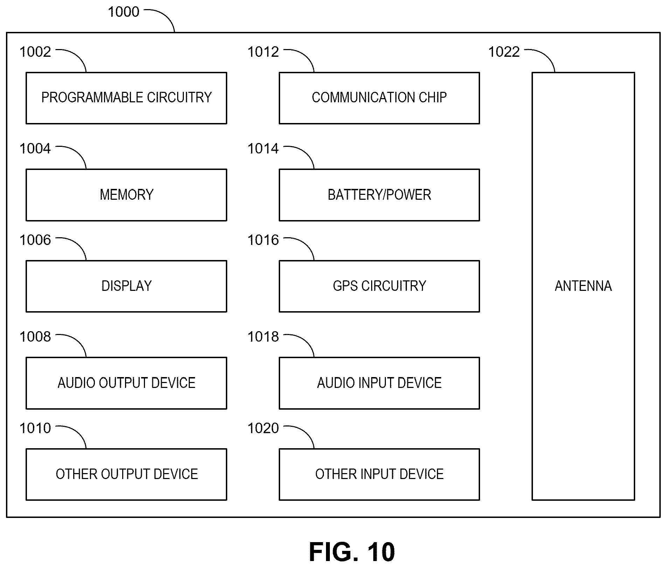

FIG. 10 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although some of the figures show layers and regions with clean lines and boundaries, some or all of these lines and/or boundaries may be idealized. In reality, the boundaries and/or lines may be unobservable, blended, and/or irregular.

### DETAILED DESCRIPTION

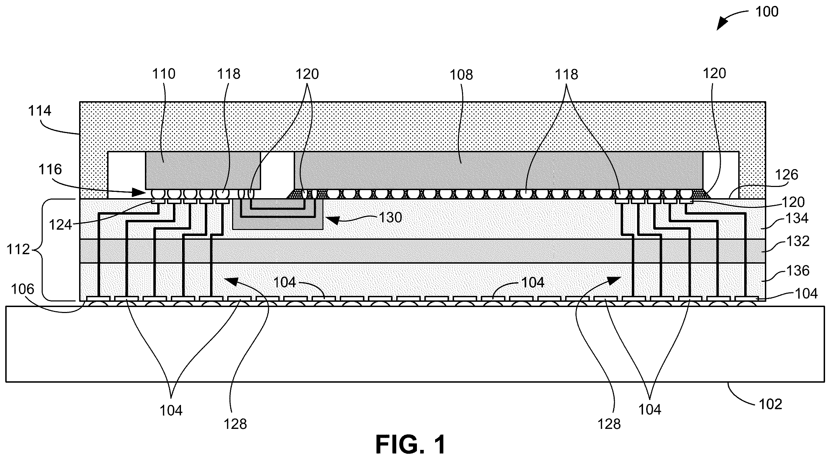

FIG. 1 illustrates an example integrated circuit (IC) package 100 constructed in accordance with teachings disclosed herein. In the illustrated example, the IC package 100 is electrically coupled to an underlying substrate 102 via an array of contacts 104 on a package mounting surface 106 (e.g., a bottom surface, an external surface) of the package. In some examples, the substrate 102 can be implemented by a package substrate or a printed circuit board (PCB). In the illustrated example, the contacts 104 are represented as pads or lands. However, in some examples, the IC package 100 may include balls, pins, and/or any other type of contact, in addition to or instead of the pads or lands shown to enable the electrical coupling of the IC package 100 to the substrate 102. In this example, the package 100 includes two semiconductor dies 108, 110 (e.g., silicon dies), sometimes also referred to as chips or chiplets, that are mounted to a package substrate 112 and enclosed by a package lid 114 (e.g., a mold compound, an integrated heat spreader (IHS)). Thus, the package substrate 112 is an example means for supporting a semiconductor die. In some examples, the package lid 114 is omitted, thereby leaving the semiconductor dies 108, 110 exposed or bare.

While the example IC package 100 of FIG. 1 includes two dies 108, 110, in other examples, the IC package 100 may have only one die or more than two dies. In some examples, one of the dies 108, 110 (or a separate die) is embedded in the package substrate 112. The dies 108, 110 can provide any suitable type of functionality (e.g., data processing, memory storage, etc.). In some examples, one or both of the dies 108, 110 are implemented by a die package including multiple dies arranged in a stacked formation. For example, the die 110 can include a stack of Dynamic Random Access Memory (DRAM) die arranged on top of a memory controller die to form a memory die stack.

As shown in the illustrated example, each of the dies 108, 110 is electrically and mechanically coupled to the package substrate 112 via corresponding arrays of interconnects 116. In FIG. 1, the interconnects are shown as bumps. The interconnects 116 can include solder joints, micro bumps, combinations of metallic (e.g., copper) pillars and solder, etc. In other examples, the interconnects 116 may include directly bonded or "hybrid bonded" metallic interconnects. In other examples, the interconnects 116 may be any other type of electrical connection in addition to or instead of the bumps shown (e.g., balls, pins, pads, pillars, wire bonding, etc.). The electrical connections between the dies 108, 110 and the package substrate 112 (e.g., the interconnects 116) are sometimes referred to as first level interconnects. By contrast, the electrical connections between the IC package 100 and the substrate 102 (e.g., the pads 104) are sometimes referred to as second level interconnects. In some examples, one or both of the dies 108, 110 may be stacked on top of one or more other dies and/or an interposer. In such examples, the dies 108, 110 are coupled to the underlying die and/or interposer through a first set of first level interconnects and the underlying die and/or interposer may be connected to the package substrate 112 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

As shown in FIG. 1, the interconnects 116 of the first level interconnects include two different types of bumps corresponding to core bumps 118 and bridge bumps 120. As used herein, the core bumps 118 are bumps on the dies 108, 110 through which electrical signals pass between the dies 108, 110 and components external to the IC package 100. More particularly, as shown in the illustrated example, when the dies 108, 110 are mounted to the package substrate 112, the core bumps 118 are physically connected and electrically coupled to contact pads 124 on a die mounting surface 126 (e.g., an upper surface, a top surface, etc.) of the package substrate 112. The contact pads 124 on the die mounting surface 126 of the package substrate 112 are electrically coupled to the contacts 104 on the package mounting surface 106 (e.g., the bottom, external surface) of the package substrate 112 (e.g., a surface opposite the die mounting surface 126) via internal interconnects 128 within the package substrate 112. As a result, there is a continuous electrical signal path between the core bumps 118 of the dies 108, 110 and the contacts 104 mounted to the substrate 102 that pass through the contact pads 124 and the interconnects 128 provided therebetween. As shown, the package mounting surface 106 and the die mounting surface 126 define opposing outer surfaces of the package substrate 110. While both surfaces are outer surfaces of the package substrate, the die mounting surface 126 is sometimes referred to herein as an internal or inner surface relative to the overall IC package 100. By contrast, in this example, the package mounting surface 106 is an outer or exterior surface of the IC package 100.

As used herein, the bridge bumps 120 are bumps on the dies 108, 110 through which electrical signals pass between different ones of the dies 108, 110 within the IC package 100. Thus, as shown in the illustrated example, the bridge bumps 120 of the first die 108 are electrically coupled to the bridge bumps 120 of the second die 110 via an interconnect bridge 130 (e.g., a silicon-based interconnect bridge, an interconnect die, an embedded interconnect bridge (EMIB)) embedded in the package substrate 112. As represented in FIG. 1, core bumps 118 are typically larger than bridge bumps 120. In some examples, the interconnect bridge 130 and the associated bridge bumps 120 are omitted.

In some examples, an underfill material 122 is disposed between the dies 108, 110 and the package substrate 112 around and/or between the first level interconnects 116 (e.g., around and/or between the core bumps 118 and/or the bridge bumps 120). In the illustrated example, only the first die 108 is associated with the underfill material 122. However, in other examples, both dies 108, 110 are associated with the underfill material 122. In other examples, the underfill material 122 is omitted. In some examples, the mold compound used for the package lid 114 is used as an underfill material that surrounds the first level interconnects 116.

In some examples, the IC package 100 includes additional passive components, such as surface-mount resistors, capacitors, and/or inductors disposed on the package mounting surface 106 of the package substrate 112 and/or the die mounting surface 126 of the package substrate 112.

In FIG. 1, the substrate 112 of the example IC package 100 includes a glass core 132 (e.g., a glass substrate, a glass layer, etc.) between two separate build-up layers or regions 134, 136 (e.g., a first build-up region 134 and a second build-up region 136). In some examples, the glass core 132 includes at least one of: aluminosilicate, borosilicate, alumino-borosilicate, silica, and/or fused silica. In some examples, the glass core 132 includes one or more additives including: aluminum oxide (Al₂O₃), boron trioxide (B₂O₃), magnesia oxide (MgO), calcium oxide (CaO), stoichiometric silicon oxide (SrO), barium oxide (BaO), stannic oxide (SnO₂), nickel alloy (Na₂O), potassium oxide (K₂O), phosphorus trioxide (P₂O₃), zirconium dioxide (ZrO₂), lithium oxide (Li₂O), titanium (Ti), and/or zinc (Zn). In some examples, the glass core 132 includes silicon and oxygen. In some examples, the glass core 132 includes silicon, oxygen and/or one or more of aluminum, boron, magnesium, calcium, barium, tin, sodium, potassium, strontium, phosphorus, zirconium, lithium, titanium, and/or zinc. In some examples, the glass core 132 includes at least 23 percent silicon by weight and at least 26 percent oxygen by weight. In some examples, the glass core is a layer of glass including silicon, oxygen and aluminum. In some examples, the glass core 132 includes at least 23 percent silicon by weight, at least 26 percent oxygen by weight, and at least 5 percent aluminum by weight.

In some examples, the glass core 132 is an amorphous solid glass layer. In some examples, the glass core 132 is a layer of glass that does not include an organic adhesive or an organic material. In some examples, the glass core 132 is a solid layer of glass having a rectangular shape in plan view. In some examples, the glass core 132, as a glass substrate, includes at least one glass layer and does not include epoxy and does not include glass fibers (e.g., does not include an epoxy-based prepreg layer with glass cloth). In some examples, the core 132 corresponds to a single piece of glass that extends the full height/thickness of the core. In other examples, the glass core 132 can be silicon, a dielectric material and/or any other material(s).

In some examples, the glass core 132 has a rectangular shape that is substantially coextensive, in plan view, with the layers above and/or below the core. In some examples, the glass core 132 has a thickness in a range of about 50 micrometers (µm) to about 1.4 millimeters (mm). In some examples, the glass core 132 can be a multi-layer glass substrate (e.g., a coreless substrate), where a glass layer has a thickness in a range of about 25 µm to about 50 µm. In some examples, the glass core 132 can have dimensions of about 10 mm on a side to about 250 mm on a side (e.g., 10 mm by 10 mm to 250 mm by 250 mm). In some examples, the glass core 132 corresponds to a rectangular prism volume with sections (e.g., vias) removed and filled with other materials (e.g., metal). Among other things, glass cores are advantageous over epoxy-based cores because glass is stiffer and, therefore, provides for greater mechanical support or strength for the package substrate. Thus, the glass core 132 is an example means for strengthening the package substrate.

The first and second build-up regions 134, 136 are represented in FIG. 1 as masses/blocks with the internal interconnects 128 extending in straight lines through the build-up regions 134, 136 (and the glass core 132). However, FIG. 1 has been simplified for the sake of clarity and purposes of explanation. In practice, the interconnects are not necessarily straight. More particularly, in some examples, the build-up regions 134, 136 are defined by alternating layers of dielectric material and layers of conductive material (e.g., a metal such as copper). The conductive (metal) layers serve as the basis for the internal interconnects 128 represented, in a simplified form, by straight lines as shown in FIG. 1. In some examples, the metal layers are patterned to define electrical routing or conductive traces that are electrically coupled between different metal layers by conductive (e.g., metal) vias extending through intervening dielectric layers.

Using glass as a starting core material (e.g., the glass core 132 of FIG. 1) has a mechanical benefit (e.g., reduced warpage, smaller thickness variation), an electrical benefit, and a design flexibility benefit (e.g., tighter through hole pitch, finer core routing) over using traditional organic core materials (e.g., epoxy-based prepreg). For example, the glass core 132 can support multi-chip packaging (e.g., embedded multi die interconnect bridge (EMIB), 2.5D/3D heterogeneous integration, hyper chip stacking (silicon (Si) interposers), etc.), reduced first level interconnect (FLI) bump pitches (e.g., less than 30 micrometer (µm)), reduced fine line spacing (FLS) (e.g., 2/2 µm), higher density interconnects, higher input/output (I/O) density patterning, increasing form factors, and decreasing package thicknesses over the traditional organic core materials. To further facilitate these advantages, the glass core 132 can include through-glass vias (TGVs) (e.g., copper plated vias) extending through the glass core 132 to electrically couple the first build-up region 134 to the second build-up region 136.

Differences in the coefficients of thermal expansion (CTEs) between copper and glass induce a stress at interfaces between the copper plating in the TGVs and the glass core 132. Such an interface can be located adjacent an inner wall of an opening of the glass core 132, wherein the inner wall contacts the copper of a TGV. In such examples, a defect (e.g., a crack, warpage, etc.) forms in the inner wall in response to the stress caused by the expansion and/or contraction of the copper relative to the glass. For example, as the IC package 100 undergoes thermal treatments or other high temperature processes, the copper in the TGV expands beyond its original shape to push against the inner wall of the opening in the glass core. In such examples, the inner wall cracks under the force of the expanding copper. These defects can reduce the reliability of the glass core 132 and, thus, can necessitate repair and/or replacement of the glass core 132. Previous solutions to overcome cracking in the glass core 132 include stress absorbing liners (e.g., including parylene) and conformally plated TGVs. However, the stress absorbing liners are financially costly and time expensive. Further, conformally plated TGVs limit TGV pitch and size scaling.

Examples disclosed herein provide space in an example opening of an example glass core associated with a TGV to enable expansion and/or contraction of copper. For example, disclosed examples include example package substrates having example gaps, voids, empty spaces, room, etc., between the copper of the TGV and an example inner wall of the opening in the glass core. Disclosed examples include an example method of manufacturing that results in the copper of the TGV being properly sized relative to (e.g., smaller than) openings in the glass core (e.g., via layer by layer plating or bottom up plating). Thus, in examples disclosed herein, the copper of the TGV can expand into an example void (e.g., during thermal treatments of a corresponding IC package) with little to no resulting force on the inner wall of the glass core. In some examples, an example layer of material (e.g., healing layer) extends into or otherwise fills cracks or defects in the glass core to help "heal" the defects. As such, disclosed examples protect glass cores from the potentially damaging effects of cracking under pressure from expanding copper, CTE mismatches, etc.

FIG. 2A is a cross-sectional view of an example first package substrate 200 constructed in accordance with teachings disclosed herein. The example first package substrate 200 of FIG. 2A is an example implementation of the package substrate 112 of FIG. 1. As such, the description of features in FIG. 1 provided above applies to the corresponding features shown and described in FIG. 2A. The example first package substrate 200 includes an example glass core 202 (e.g., glass layer) having example openings 204a, 204b, 204c (e.g., holes, cavities, etc.) extending between example first and second surfaces 206, 208 of the glass core 202. The example first surface 206 is opposite the second surface 208. Further, the example first package substrate 200 includes example conductive material(s) 210a, 210b, 210c (e.g., metal, copper, etc.) positioned within corresponding ones of the openings 204a, 204b, 204c. As such, the example conductive materials 210a, 210b, 210c within the openings 204a, 204b, 204c define example TGVs.

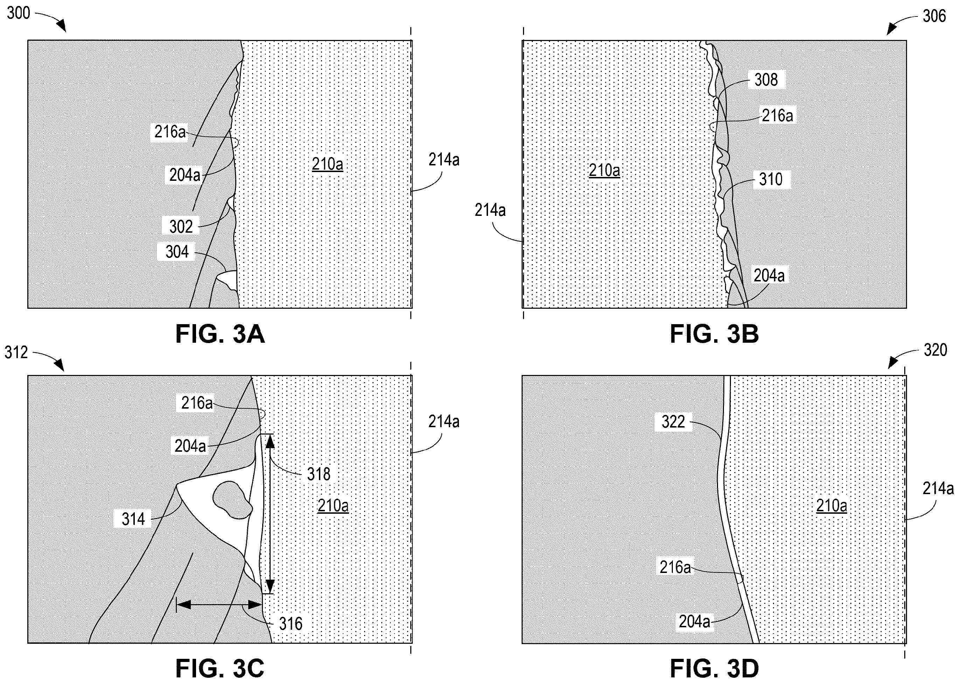

The example conductive materials 210a, 210b, 210c are spaced apart from the glass core 202 by example voids 212a, 212b, 212c (e.g., spaces, gaps, etc.) in a radial direction relative to example longitudinal axes 214a, 214b, 214c (e.g., elongate axes) of the TGVs. In some examples, corresponding dimensions of the voids 212a, 212b, 212c are measured in the radial direction relative to the longitudinal axes 214a, 214b, 214c. For example, a dimension of the void 212a in the radial direction relative to the longitudinal axis 214a is in a range from 25 nanometers (nm) to 250 nm. The example void 212a is positioned between an interface of the conductive material 210a and an example sidewall 216a (e.g., inner wall) of the opening 204a. Similarly, the example void 212b is positioned between an interface of the conductive material 210b and an example sidewall 216b of the opening 204b, and the example void 212c is positioned between an interface of the conductive material 210c and an example sidewall 216c of the opening 204c. In some examples, the sidewalls 216a, 216b, 216c are tapered. In some examples, the sidewalls 216a, 216b, 216c include example openings, cavities, empty spaces, defects, etc., as described in connection with at least FIGS. 3A-3D. In such examples, the conductive materials 210a, 210b, 210c are separated from the sidewalls 216a, 216b, 216c by empty spaces in the openings in the sidewalls 216a, 216b, 216c. In some examples, there is no metal seed layer on the glass core 202 between the conductive materials 210a, 210b, 210c and the corresponding sidewalls 216a, 216b, 216c.

The example first package substrate 200 includes example dielectric layers 218, 220 to cover the respective first and second surfaces 206, 208 of the glass core 202. In some examples, the dielectric layers 218, 220 include silicon nitride (SiNₓ). In some examples, the dielectric layers 218, 220 promote adhesion between the conductive materials 210a, 210b, 210c and example buffer layers 219, 221. The example voids 212a, 212b, 212c extend between the dielectric layers 218, 220. For example, the void 212a is an elongate gap extending along the sidewall 216a such that the void 212a includes a first end that extends to the dielectric layer 218 and a second end that extends to the dielectric layer 220. Put differently, the example dielectric layer 218 defines a first end of the void 212a and the dielectric layer 220 defines a second end of the void 212a. Similarly, the example dielectric layers 218, 220 define ends of the voids 212b, 212c. In other examples, the voids 212a, 212b, 212c do not extend continuously along the full length of the TGVs. For instance, in some examples, the conductive materials 210a, 210b, 210c may contact the corresponding sidewalls 216a, 216b, 216c at one or more locations between the example dielectric layers 218, 220. However, in some examples, at least a majority (e.g., at least 50%, at least 60%, at least 65%, at least 75%, at least 80%, at least 90%) of a longitudinal length of the TGVs (e.g., the conductive materials 210a, 210b, 210c) is spaced apart from the corresponding sidewalls 216a, 216b, 216c with the voids 212a, 212b, 212c therebetween.

FIG. 2B is a cross-sectional view of an example second package substrate 222 constructed in accordance with teachings disclosed herein. The example second package substrate 222 of FIG. 2B is another example implementation of the package substrate 112 of FIG. 1. As such, the description of features in FIG. 1 provided above applies to the corresponding features shown and described in FIG. 2A. The example second package substrate 222 of FIG. 2B is similar to the example first package substrate 200 of FIG. 2A. Thus, the same reference numbers used in FIGS. 2A will be used for the same or similar features shown in FIGS. 2B. Further, the description of such features provided above in connection with FIG. 2A applies similarly to the same features shown in FIG. 2B except as noted below or otherwise made clear from the context.

The example second package substrate 222 of FIG. 2B includes the glass core 202, the openings 204a, 204b, 204c, the sidewalls 216a, 216b, 216c, the conductive materials 210a, 210b, 210c, the dielectric layers 218, 220, and the voids 212a, 212b, 212c. Further, the example second package substrate 222 includes example healing layers 224a, 224b, 224c on corresponding ones of the sidewalls 216a, 216b, 216c. The example healing layer 224a is between the sidewall 216a and the void 212a. Similarly, the example healing layer 224b is between the sidewall 216b and the void 212b, and the healing layer 224c is between the sidewall 216c and the void 212c. In some examples, the healing layers 224a, 224b, 224c include parylene. In some examples, the healing layers 224a, 224b, 224c include silicon nitride (SiNₓ). In some examples, the healing layers 224a, 224b, 224c have a low modulus of elasticity (e.g., in a range from about 0.5 gigapascal (GPa) to 3 GPa). In some examples, each of the healing layers 224a, 224b, 224c has a thickness of less than about 1 micrometer (µm). In some examples, the healing layers 224a, 224b, 224c extend into cavities, spaces, cracks, voids, defects, etc., in the sidewalls 216a, 216b, 216c. In some examples, the healing layers 224a, 224b, 224c induce a compressive force on the glass core 202 to strengthen or support the glass core 202a.

FIG. 3A is a detailed view of an example first interface 300 that can be included in the first package substrate 200 of FIG. 2A or the second package substrate 222 of FIG. 2B. The example first interface 300 includes a portion of the opening 204a, the sidewall 216a, the conductive material 210a, an example first gap 302, and an example second gap 304. The different gaps 302, 304 shown in FIG. 3 illustrate an example of at least portions of the void 212a between the conductive material 210a and the sidewall 216a as discussed above in connection with FIGS. 2A and 2B. The example first gap 302 is associated with a first position along the longitudinal axis 214a. The example second gap 304 is associated with a second position along the longitudinal axis 214a. The example first gap 302 has a first size. The example second gap 304 has a second size different from (e.g., larger than) the first size. In some examples, the first and second sizes of the respective first and second gaps 302, 304 are measured in a radial direction extending from the longitudinal axis 214a towards the sidewall 216a. For example, the first gap 302 extends a first distance towards the sidewall 216a and the second gap 304 extends a second distance towards the sidewall 216a, the second distance different from (e.g., greater than) the first distance. In some examples, the first gap 302 and/or the second gap 304 fully surrounds a circumference or other annular perimeter of the conductive material 210a.

FIG. 3B is a detailed view of an example second interface 306 that can be included in the first package substrate 200 of FIG. 2A or the second package substrate 222 of FIG. 2B. The example second interface 306 includes a portion of the opening 204a, the sidewall 216a, the conductive material 210a, an example third gap 308, and an example fourth gap 310. The different gaps 308, 310 shown in FIG. 3 illustrate an example of at least portions of the void 212a between the conductive material 210a and the sidewall 216a as discussed above in connection with FIGS. 2A and 2B. The example third and fourth gaps 308, 310 are elongate gaps extending along the longitudinal axis 214a (e.g., a direction defined by the longitudinal axis 214a). The example third gap 308 includes a first length. The example fourth gap 310 includes a second length different from (e.g., longer than) the first length.

FIG. 3C is a detailed view of an example third interface 312 that can be included in the first package substrate 200 of FIG. 2A or the second package substrate 222 of FIG. 2B. The example third interface 312 includes a portion of the opening 204a, the sidewall 216a, the conductive material 210a, and an example fifth gap 314. The example fifth gap 314 shown in FIG. 3 illustrates an example of at least a portion of the void 212a between the conductive material 210a and the sidewall 216a as discussed above in connection with FIGS. 2A and 2B. The example fifth gap 314 tapers in size in the radial direction. For example, the fifth gap 314 tapers in size in the radial direction from the longitudinal axis 214a to the sidewall 216a. Further, the example fifth gap 314 extends an example first distance 316 along the radial direction and an example second distance 318 along the longitudinal axis 214a (e.g., a longitudinal direction defined by the longitudinal axis 214a). In some examples, the second distance 318 is at least twice the first distance 316.

FIG. 3D is a detailed view of an example fourth interface 320 that can be included in the first package substrate 200 of FIG. 2A or the second package substrate 222 of FIG. 2B. The example fourth interface 320 includes a portion of the opening 204a, the sidewall 216a, the conductive material 210a, and an example sixth gap 322. The example sixth gap 322 shown in FIG. 3 illustrates an example of at least a portion of the void 212a between the conductive material 210a and the sidewall 216a as discussed above in connection with FIGS. 2A and 2B. The example sixth gap 322 is another example elongate gap that extends in a longitudinal direction (e.g., aligned with the longitudinal direction) across the sidewall 216a and the conductive material 210a. In some examples, the sixth gap 322 extends a full distance in the longitudinal direction between the example dielectric layers 218, 220, as described in connection with FIGS. 2A and 2B. In some examples, the sixth gap 322 is aligned with (e.g., conformally follows) a curve of the sidewall 216a and/or a curve of the conductive material 210a. In some examples, any of the gaps 302, 304, 308, 314, 322 are aligned with or adjacent to a void or other defect in the glass core. For example, the fifth gap 314 (FIG. 3C) is positioned between the void and the conductive material 210a.

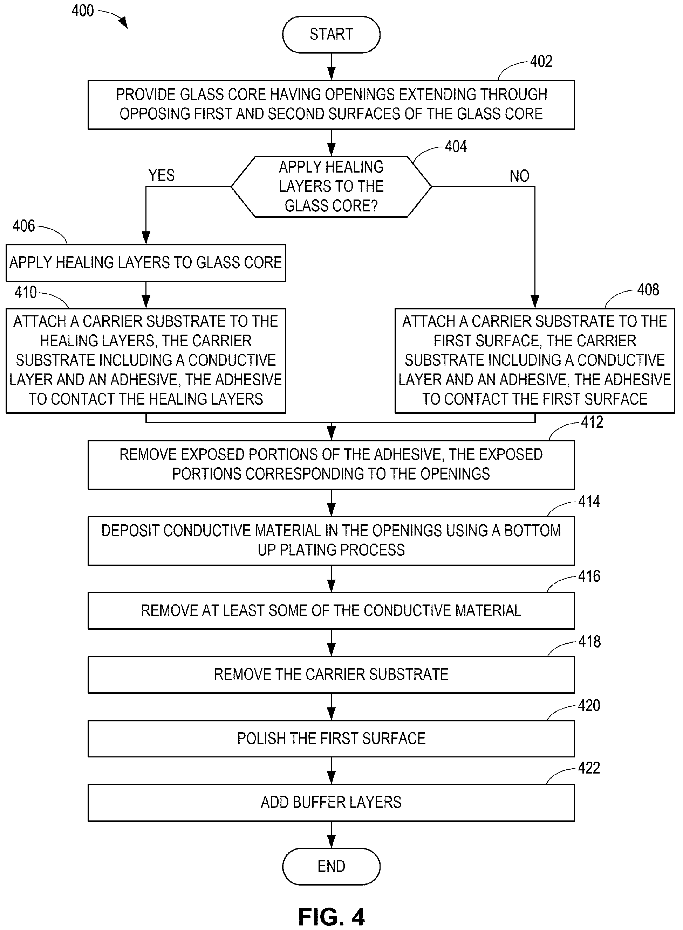

FIG. 4 is a flowchart representative of an example method 400 to produce the example first package substrate 200 of FIG. 2A and/or the example second package substrate 222 of FIG. 2B. FIGS. 5A-5G represent the example first package substrate 200 at various stages during the example process described in FIG. 4. FIGS. 5A-5B and 6A-6G represent the example second package substrate 222 at various stages during the example process described in FIG. 4. In some examples, some or all of the operations outlined in the example method 400 of FIG. 4 are performed automatically by fabrication equipment (e.g., High Volume Manufacturing (HVM) equipment) that is programmed to perform the operation. Although the example method of manufacture is described with reference to the flowchart illustrated in FIG. 4, many other methods may alternatively be used. For example, the order of execution of the blocks may be changed, and/or some of the blocks described may be combined, divided, re-arranged, omitted, eliminated, and/or implemented in any other way. Further, in some examples, additional processing operations can be performed before, between, and/or after any of the blocks represented in the illustrated example.

Turning to FIG. 4, the example process begins at block 402, at which the example glass core 202 is provided, the glass core 202 having openings 204a, 204b, 204c extending through the first and second opposing surfaces 206, 208 of the glass core 202, as shown in FIGS. 5A and 5B. In some examples, the openings 204a, 204b, 204c are provided in the glass core 202 through a laser induced deep etching (LIDE) process.

At block 404, it is determined whether to apply the example healing layers 224a, 224b, 224c to the glass core 202. If the example healing layers 224a, 224b, 224c are to be applied to the glass core 202, then the process proceeds to block 406, as discussed below in connection with FIGS. 6A-6G. In the example process illustrated by FIGS. 5A-5G, the example healing layers 224a, 224b, 224c are not to be applied to the glass core 202. In such examples, the process proceeds to block 408.

At block 408, an example carrier substrate 500 is attached to the first surface 206, the carrier substrate 500 including an example conductive layer 502 and an example adhesive, the example adhesive to contact the first surface 206, as shown in FIG. 5C. The example adhesive covers the conductive layer 502 such that the adhesive is positioned between the first surface 206 and the conductive layer 502. In some examples, the adhesive is conductive.

Returning to block 404, if it is determined that the example healing layers 224a, 224b, 224c are to be applied to the glass core 202, then the process proceeds to block 406 with the subsequent stages of fabrication represented by FIGS. 6A-6G. At block 406, the example healing layers 224a, 224b, 224c are applied to the glass core 202, as shown in FIG. 6A. In some examples, the healing layers 224a, 224b, 224c are deposited using any suitable thin film deposition process (e.g., physical vapor deposition (PVD), chemical vapor deposition (CVD), atomic layer deposition (ALD), spin coating, etc.). In some examples, the healing layers 224a, 224b, 224c conformally coat all exposed surfaces of the underlying structure. Thus, as shown in the illustrated example of FIG. 6A, the healing layers 224a, 224b, 224c extend along the first and second surfaces 206, 208 of the glass core 202 as well as along the sidewalls of the openings 204a, 204b, 204c extending through the glass core 202.

At block 410, the example carrier substrate 500 is attached to the healing layers 224a, 224b, 224c, the carrier substrate 500 including the conductive layer 502 and the adhesive, the adhesive to contact the healing layers 224a, 224b, 224c, as shown in FIG. 6B. For example, the adhesive is to contact portions of the healing layers 224a, 224b, 224c adjacent to the first surface 206. The example healing layers 224a, 224b, 224c are positioned between the first surface 206 and the adhesive.

At block 412, exposed portions of the example adhesive are removed, the exposed portions corresponding to the openings 204a, 204b, 204c. In some examples, the exposed portions of the adhesive span or otherwise extend across a length (e.g., diameter) of each of the openings 204a, 204b, 204c. In some examples, the exposed portions of the adhesive are not covered by the first surface 206 or the portions of the healing layers 224a, 224b, 224c adjacent to the first surface 206. In some examples, where the adhesive is omitted or composed of a conductive material, block 412 may be omitted.

At block 414, the example conductive materials 210a, 210b, 210c are deposited in the openings 204a, 204b, 204c using an example bottom up plating process, as shown in FIGS. 5D and 6C. In some examples, the bottom up plating process includes depositing (e.g., via electroplating) a first layer of the conductive material 210a to cover the portion of the conductive layer 502 where the adhesive was removed (block 412) (e.g., at the bottom of the opening 204a), depositing a second layer of the conductive material 210a to cover the first layer, depositing a third layer of the conductive material 210a to cover the second layer, etc., until subsequent layers of the conductive material 210a reach or exceed the second surface 208 of the glass core 202. Similarly, the example conductive materials 210b, 210c are deposited on portions of the conductive layer 502 corresponding to the respective openings 204b, 204c by the bottom up plating process. In some examples, the successive layers of conductive material 210a, 210b, 210c deposited into the openings 204a, 204b, 204c are deposited through one continuous plating process. In FIG. 5D, excess of the conductive materials 210a, 210b, 210c is deposited to cover the second surface 208. In FIG. 6C, excess of the conductive materials 210a, 210b, 210c is applied to cover the second surface 208 and portions of the healing layers 224a, 224b, 224c adjacent to the second surface 208.

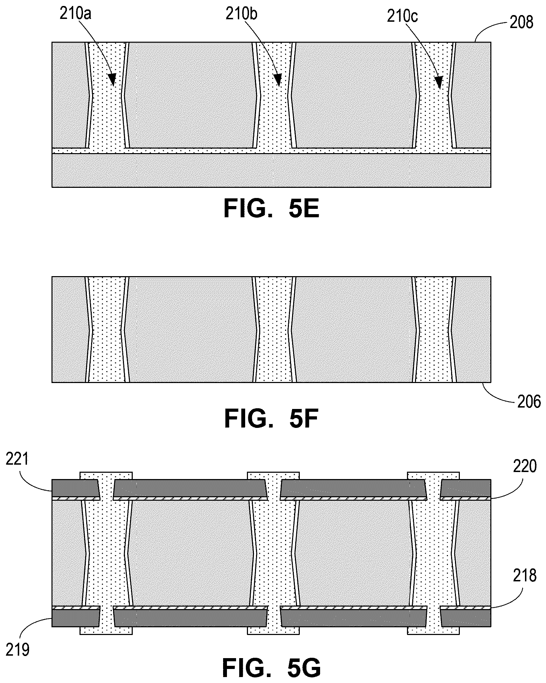

At block 416, at least some of the example conductive materials 210a, 210b, 210c are removed, as shown in FIGS. 5E and 6D. In FIG. 5E, the excess of the conductive materials 210a, 210b, 210c is removed from the second surface 208. In FIG. 6D, the excess of the conductive materials 210a, 210b, 210c is removed from the portions of the healing layers 224a, 224b, 224c adjacent to the second surface 208. In some examples, the excess of the conductive materials 210a, 210b, 210c is removed via chemical mechanical planarization (CMP) or polishing CMP. In some examples, this CMP process also removes the healing layers 224a, 224b, 224c to expose the second surface 208 of the glass core 202, as shown in FIG. 6D. In some examples, at least some of the glass core 202 may also be removed during the CMP process.

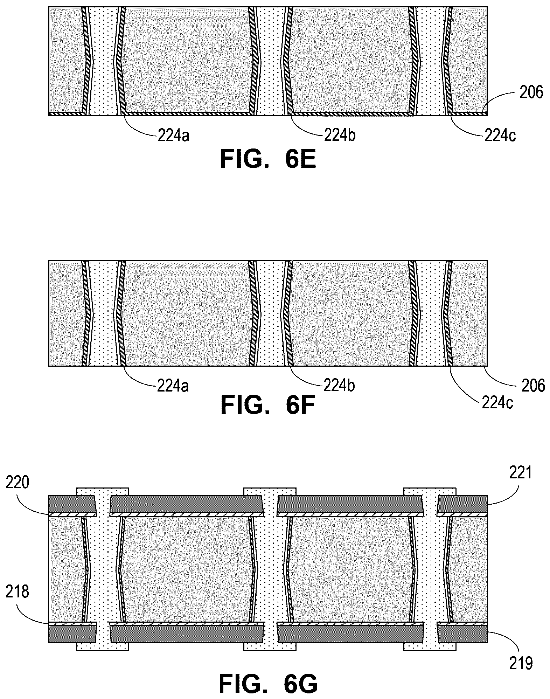

At block 418, the example carrier substrate 500 is removed, as shown in FIGS. 5F and 6E. In FIG. 5F, the example carrier substrate 500 is removed (e.g., detached) from the first surface 206 of the glass core 202. In FIG. 6E, the example carrier substrate 500 is removed (e.g., detached) from the portions of the healing layers 224a, 224b, 224c adjacent to the first surface 206 of the glass core 202.

At block 420, the example first surface 206 is polished, as shown in FIGS. 5F and 6F. In FIG. 6F, the first surface 206 is polished (e.g., via a CMP process) to remove the portions of the healing layers 224a, 224b, 224c adjacent to the first surface 206. In some examples, both the first and second surfaces 206, 208 may undergo a cleaning process to remove any residue from the polishing processes.

At block 422, the example buffer layers 219, 221 are added, as shown in FIGS. 5G and 6G. In some examples, the buffer layers 219, 221 include the dielectric layers 218, 220, metal vias, conductive pads, conductive traces, liquid buffer layer coats, etc. Then, the process ends.

The example first and second package substrates 200, 222 may be implemented in the example IC package 100 of FIG. 1, which may be included in any suitable electronic component. FIGS. 7-10 illustrate various examples of apparatus that may include or be included in the example IC package 100 containing either of the example first and second package substrates 200, 222 disclosed herein.

FIG. 7 is a top view of a wafer 700 and dies 702 that may be included in the IC package 100 of FIG. 1 (e.g., as any suitable ones of the dies 108, 110). The wafer 700 includes semiconductor material and one or more dies 702 having circuitry. Each of the dies 702 may be a repeating unit of a semiconductor product. After the fabrication of the semiconductor product is complete, the wafer 700 may undergo a singulation process in which the dies 702 are separated from one another to provide discrete "chips." The die 702 includes one or more transistors (e.g., some of the transistors 840 of FIG. 8, discussed below), supporting circuitry to route electrical signals to the transistors, passive components (e.g., traces, resistors, capacitors, inductors, and/or other circuitry), and/or any other components. In some examples, the die 702 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry or electronics. Multiple ones of these devices may be combined on a single die 702. For example, a memory array of multiple memory circuits may be formed on a same die 702 as programmable circuitry (e.g., the programmable circuitry 1002 of FIG. 10) and/or other logic circuitry. Such memory may store information for use by the programmable circuitry. The example IC package 100 disclosed herein may be manufactured using a die-to-wafer assembly technique in which some dies are attached to a wafer 700 that includes others of the dies, and the wafer 700 is subsequently singulated.

FIG. 8 is a cross-sectional side view of an IC device 800 that may be included in the IC package 100 of FIG. 1 (e.g., as any one of the dies 108, 11). One or more of the IC devices 800 may be included in one or more dies 702 (FIG. 7). The IC device 800 may be formed on a die substrate 802 (e.g., the wafer 700 of FIG. 7) and may be included in a die (e.g., the die 702 of FIG. 7). The die substrate 802 may be a semiconductor substrate including semiconductor materials including, for example, n-type or p-type materials systems (or a combination of both). The die substrate 802 may include, for example, a crystalline substrate formed using a bulk silicon or a silicon-on-insulator (SOI) substructure. In some examples, the die substrate 802 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 802. Although a few examples of materials from which the die substrate 802 may be formed are described here, any material that may serve as a foundation for an IC device 800 may be used. The die substrate 802 may be part of a singulated die (e.g., the dies 702 of FIG. 7) or a wafer (e.g., the wafer 700 of FIG. 7).

The IC device 800 may include one or more device layers 804 disposed on and/or above the die substrate 802. The device layer 804 may include features of one or more transistors 840 (e.g., metal oxide semiconductor field-effect transistors (MOSFETs)) formed on the die substrate 802. The device layer 804 may include, for example, one or more source and/or drain (S/D) regions 820, a gate 822 to control current flow between the S/D regions 820, and one or more S/D contacts 824 to route electrical signals to/from the S/D regions 820. The transistors 840 may include additional features not depicted for the sake of clarity, such as device isolation regions, gate contacts, and the like. The transistors 840 are not limited to the type and configuration depicted in FIG. 8 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 840 may include a gate 822 including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and/or zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 840 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included, such as a barrier layer. For a PMOS transistor, metals that may be used for the gate electrode include, but are not limited to, ruthenium, palladium, platinum, cobalt, nickel, conductive metal oxides (e.g., ruthenium oxide), and/or any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and/or aluminum carbide), and/or any of the metals discussed above with reference to a PMOS transistor (e.g., for work function tuning).

In some examples, when viewed as a cross-section of the transistor 840 along the source-channel-drain direction, the gate electrode may include a U-shaped structure that includes a bottom portion substantially parallel (e.g., within 5 degrees) to the surface of the die substrate 802 and two sidewall portions that are substantially perpendicular (e.g., within 5 degrees) to the top surface of the die substrate 802. In other examples, at least one of the metal layers that form the gate electrode may be a planar layer that is substantially parallel to the top surface of the die substrate 802 and does not include sidewall portions substantially perpendicular to the top surface of the die substrate 802. In other examples, the gate electrode may include a combination of U-shaped structures and/or planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and/or silicon oxynitride. Processes for forming sidewall spacers are well known in the art and generally include deposition and etching process operations. In some examples, a plurality of spacer pairs may be used; for instance, two pairs, three pairs, or four pairs of sidewall spacers may be formed on opposing sides of the gate stack.

The S/D regions 820 may be formed within the die substrate 802 adjacent to the gate 822 of corresponding transistor(s) 840. The S/D regions 820 may be formed using an implantation/diffusion process or an etching/deposition process, for example. In the former process, dopants such as boron, aluminum, antimony, phosphorous, or arsenic may be ion-implanted into the die substrate 802 to form the S/D regions 820. An annealing process that activates the dopants and causes them to diffuse farther into the die substrate 802 may follow the ion-implantation process. In the latter process, the die substrate 802 may first be etched to form recesses at the locations of the S/D regions 820. An epitaxial deposition process may then be carried out to fill the recesses with material that is used to fabricate the S/D regions 820. In some implementations, the S/D regions 820 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 820 may be formed using one or more alternate semiconductor materials such as germanium or a group III-V material or alloy. In further examples, one or more layers of metal and/or metal alloys may be used to form the S/D regions 820.

Electrical signals, such as power and/or input/output (I/O) signals, may be routed to and/or from the devices (e.g., transistors 840) of the device layer 804 through one or more interconnect layers disposed on the device layer 804 (illustrated in FIG. 8 as interconnect layers 806-2010). For example, electrically conductive features of the device layer 804 (e.g., the gate 822 and the S/D contacts 824) may be electrically coupled with the interconnect structures 828 of the interconnect layers 806-2010. The one or more interconnect layers 806-2010 may form a metallization stack (also referred to as an "ILD stack") 819 of the IC device 800.

The interconnect structures 828 may be arranged within the interconnect layers 806-2010 to route electrical signals according to a wide variety of designs (in particular, the arrangement is not limited to the particular configuration of interconnect structures 828 depicted in FIG. 8). Although a particular number of interconnect layers 806-2010 is depicted in FIG. 8, examples of the present disclosure include IC devices having more or fewer interconnect layers than depicted.

In some examples, the interconnect structures 828 may include lines 828a and/or vias 828b filled with an electrically conductive material such as a metal. The lines 828a may be arranged to route electrical signals in a direction of a plane that is substantially parallel with a surface of the die substrate 802 upon which the device layer 804 is formed. For example, the lines 828a may route electrical signals in a direction in and/or out of the page from the perspective of FIG. 8. The vias 828b may be arranged to route electrical signals in a direction of a plane that is substantially perpendicular to the surface of the die substrate 802 upon which the device layer 804 is formed. In some examples, the vias 828b may electrically couple lines 828a of different interconnect layers 806-2010 together.

The interconnect layers 806-2010 may include a dielectric material 826 disposed between the interconnect structures 828, as shown in FIG. 8. In some examples, the dielectric material 826 disposed between the interconnect structures 828 in different ones of the interconnect layers 806-2010 may have different compositions; in other examples, the composition of the dielectric material 826 between different interconnect layers 806-2010 may be the same.

A first interconnect layer 806 (referred to as Metal 1 or "M1") may be formed directly on the device layer 804. In some examples, the first interconnect layer 806 may include lines 828a and/or vias 828b, as shown. The lines 828a of the first interconnect layer 806 may be coupled with contacts (e.g., the S/D contacts 824) of the device layer 804.

A second interconnect layer 808 (referred to as Metal 2 or "M2") may be formed directly on the first interconnect layer 806. In some examples, the second interconnect layer 808 may include vias 828b to couple the lines 828a of the second interconnect layer 808 with the lines 828a of the first interconnect layer 806. Although the lines 828a and the vias 828b are structurally delineated with a line within each interconnect layer (e.g., within the second interconnect layer 808) for the sake of clarity, the lines 828a and the vias 828b may be structurally and/or materially contiguous (e.g., simultaneously filled during a dual-damascene process) in some examples.

A third interconnect layer 810 (referred to as Metal 3 or "M3") (and additional interconnect layers, as desired) may be formed in succession on the second interconnect layer 808 according to similar techniques and/or configurations described in connection with the second interconnect layer 808 or the first interconnect layer 806. In some examples, the interconnect layers that are "higher up" in the metallization stack 819 in the IC device 800 (i.e., further away from the device layer 804) may be thicker.

The IC device 800 may include a solder resist material 834 (e.g., polyimide or similar material) and one or more conductive contacts 836 formed on the interconnect layers 806-2010. In FIG. 8, the conductive contacts 836 are illustrated as taking the form of bond pads. The conductive contacts 836 may be electrically coupled with the interconnect structures 828 and configured to route the electrical signals of the transistor(s) 840 to other external devices. For example, solder bonds may be formed on the one or more conductive contacts 836 to mechanically and/or electrically couple a chip including the IC device 800 with another component (e.g., a circuit board). The IC device 800 may include additional or alternate structures to route the electrical signals from the interconnect layers 806-2010; for example, the conductive contacts 836 may include other analogous features (e.g., posts) that route the electrical signals to external components.

FIG. 9 is a cross-sectional side view of an IC device assembly 900 that may include the example IC package 100 containing either of the example first and second package substrates 200, 222 disclosed herein. In some examples, the IC device assembly corresponds to the example IC package 100. The IC device assembly 900 includes a number of components disposed on a circuit board 902 (which may be, for example, a motherboard). The IC device assembly 900 includes components disposed on a first face 940 of the circuit board 902 and an opposing second face 942 of the circuit board 902; generally, components may be disposed on one or both faces 940 and 942. Any of the IC packages discussed below with reference to the IC device assembly 2200 may take the form of the example IC package 100 of FIG. 1.

In some examples, the circuit board 902 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 902. In other examples, the circuit board 902 may be a non-PCB substrate.

The IC device assembly 900 illustrated in FIG. 9 includes a package-on-interposer structure 936 coupled to the first face 940 of the circuit board 902 by coupling components 916. The coupling components 916 may electrically and mechanically couple the package-on-interposer structure 936 to the circuit board 902, and may include solder balls (as shown in FIG. 9), male and female portions of a socket, an adhesive, an underfill material, and/or any other suitable electrical and/or mechanical coupling structure.

The package-on-interposer structure 936 may include an IC package 920 coupled to an interposer 904 by coupling components 918. The coupling components 918 may take any suitable form for the application, such as the forms discussed above with reference to the coupling components 916. Although a single IC package 920 is shown in FIG. 9, multiple IC packages may be coupled to the interposer 904; indeed, additional interposers may be coupled to the interposer 904. The interposer 904 may provide an intervening substrate used to bridge the circuit board 902 and the IC package 920. The IC package 920 may be or include, for example, a die (the die 702 of FIG. 7), an IC device (e.g., the IC device 800 of FIG. 8), or any other suitable component. Generally, the interposer 904 may spread a connection to a wider pitch or reroute a connection to a different connection. For example, the interposer 904 may couple the IC package 920 (e.g., a die) to a set of BGA conductive contacts of the coupling components 916 for coupling to the circuit board 902. In the example illustrated in FIG. 9, the IC package 920 and the circuit board 902 are attached to opposing sides of the interposer 904; in other examples, the IC package 920 and the circuit board 902 may be attached to a same side of the interposer 904. In some examples, three or more components may be interconnected by way of the interposer 904.

In some examples, the interposer 904 may be formed as a PCB, including multiple metal layers separated from one another by layers of dielectric material and interconnected by electrically conductive vias. In some examples, the interposer 904 may be formed of an epoxy resin, a fiberglass-reinforced epoxy resin, an epoxy resin with inorganic fillers, a ceramic material, or a polymer material such as polyimide. In some examples, the interposer 904 may be formed of alternate rigid or flexible materials that may include the same materials described above for use in a semiconductor substrate, such as silicon, germanium, and other group III-V and group IV materials. The interposer 904 may include metal interconnects 908 and vias 910, including but not limited to through-silicon vias (TSVs) 906. The interposer 904 may further include embedded devices 914, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 904. The package-on-interposer structure 936 may take the form of any of the package-on-interposer structures known in the art.

The IC device assembly 900 may include an IC package 924 coupled to the first face 940 of the circuit board 902 by coupling components 922. The coupling components 922 may take the form of any of the examples discussed above with reference to the coupling components 916, and the IC package 924 may take the form of any of the examples discussed above with reference to the IC package 920.

The IC device assembly 900 illustrated in FIG. 9 includes a package-on-package structure 934 coupled to the second face 942 of the circuit board 902 by coupling components 928. The package-on-package structure 934 may include a first IC package 926 and a second IC package 932 coupled together by coupling components 930 such that the first IC package 926 is disposed between the circuit board 902 and the second IC package 932. The coupling components 928, 930 may take the form of any of the examples of the coupling components 916 discussed above, and the IC packages 926, 932 may take the form of any of the examples of the IC package 920 discussed above. The package-on-package structure 934 may be configured in accordance with any of the package-on-package structures known in the art.

FIG. 10 is a block diagram of an example electrical device 1000 that may include one or more of the example IC package 100 containing either of the example first and second package substrates 200, 222. For example, any suitable ones of the components of the electrical device 1000 may include one or more of the device assemblies 900, IC devices 800, or dies 702 disclosed herein, and may be arranged in the example IC package 100. A number of components are illustrated in FIG. 10 as included in the electrical device 1000, but any one or more of these components may be omitted or duplicated, as suitable for the application. In some examples, some or all of the components included in the electrical device 1000 may be attached to one or more motherboards. In some examples, some or all of these components are fabricated onto a single system-on-a-chip (SoC) die.

Additionally, in various examples, the electrical device 1000 may not include one or more of the components illustrated in FIG. 10, but the electrical device 1000 may include interface circuitry for coupling to the one or more components. For example, the electrical device 1000 may not include a display 1006, but may include display interface circuitry (e.g., a connector and driver circuitry) to which a display 1006 may be coupled. In another set of examples, the electrical device 1000 may not include an audio input device 1018 (e.g., microphone) or an audio output device 1008 (e.g., a speaker, a headset, earbuds, etc.), but may include audio input or output device interface circuitry (e.g., connectors and supporting circuitry) to which an audio input device 1018 or audio output device 1008 may be coupled.

The electrical device 1000 may include programmable circuitry 1002 (e.g., one or more processing devices). The programmable circuitry 1002 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1000 may include a memory 1004, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 1004 may include memory that shares a die with the programmable circuitry 1002. This memory may be used as cache memory and may include embedded dynamic random access memory (eDRAM) or spin transfer torque magnetic random access memory (STT-MRAM).

In some examples, the electrical device 1000 may include a communication chip 1012 (e.g., one or more communication chips). For example, the communication chip 1012 may be configured for managing wireless communications for the transfer of data to and from the electrical device 1000. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 1012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1012 may operate in accordance with other wireless protocols in other examples. The electrical device 1000 may include an antenna 1022 to facilitate wireless communications and/or to receive other wireless communications (such as AM or FM radio transmissions).

In some examples, the communication chip 1012 may manage wired communications, such as electrical, optical, or any other suitable communication protocols (e.g., the Ethernet). As noted above, the communication chip 1012 may include multiple communication chips. For instance, a first communication chip 1012 may be dedicated to shorter-range wireless communications such as Wi-Fi or Bluetooth, and a second communication chip 1012 may be dedicated to longer-range wireless communications such as global positioning system (GPS), EDGE, GPRS, CDMA, WiMAX, LTE, EV-DO, or others. In some examples, a first communication chip 1012 may be dedicated to wireless communications, and a second communication chip 1012 may be dedicated to wired communications.

The electrical device 1000 may include battery/power circuitry 1014. The battery/power circuitry 1014 may include one or more energy storage devices (e.g., batteries or capacitors) and/or circuitry for coupling components of the electrical device 1000 to an energy source separate from the electrical device 1000 (e.g., AC line power).

The electrical device 1000 may include a display 1006 (or corresponding interface circuitry, as discussed above). The display 1006 may include any visual indicators, such as a heads-up display, a computer monitor, a projector, a touchscreen display, a liquid crystal display (LCD), a light-emitting diode display, or a flat panel display.

The electrical device 1000 may include an audio output device 1008 (or corresponding interface circuitry, as discussed above). The audio output device 1008 may include any device that generates an audible indicator, such as speakers, headsets, or earbuds.

The electrical device 1000 may include an audio input device 1018 (or corresponding interface circuitry, as discussed above). The audio input device 1018 may include any device that generates a signal representative of a sound, such as microphones, microphone arrays, or digital instruments (e.g., instruments having a musical instrument digital interface (MIDI) output).

The electrical device 1000 may include GPS circuitry 1016. The GPS circuitry 1016 may be in communication with a satellite-based system and may receive a location of the electrical device 1000, as known in the art.

The electrical device 1000 may include any other output device 1010 (or corresponding interface circuitry, as discussed above). Examples of the other output device 1010 may include an audio codec, a video codec, a printer, a wired or wireless transmitter for providing information to other devices, or an additional storage device.

The electrical device 1000 may include any other input device 1020 (or corresponding interface circuitry, as discussed above). Examples of the other input device 1020 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1000 may have any desired form factor, such as a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device. In some examples, the electrical device 1000 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that provide space in an example opening of an example glass core associated with a TGV to enable expansion and/or contraction of copper. For example, disclosed examples include example package substrates having example gaps, voids, empty spaces, room, etc., between the copper of the TGV and an example inner wall of the opening in the glass core. Disclosed examples include an example method of manufacturing that results in the copper of the TGV being properly sized relative to (e.g., smaller than) openings in the glass core (e.g., via layer by layer plating or bottom up plating). Thus, in examples disclosed herein, the copper of the TGV can expand into an example void (e.g., during thermal treatments of a corresponding IC package) with little to no resulting force on the inner wall of the glass core. In some examples, disclosed examples provide an example buffer layer to extend into or otherwise fill cracks and/or voids in the glass core. As such, disclosed examples protect glass cores from the potentially damaging effects of glass defects under pressure from expanding copper, CTE mismatches, etc.

Example 1 includes an apparatus comprising a glass layer having an opening extending between opposing surfaces of the layer core, a metal within the opening, and a gap between the metal and a sidewall of the opening.

Example 2 includes the apparatus of example 1, wherein the sidewall of the opening is tapered.

Example 3 includes the apparatus of example 1 or example 2, wherein there is no metal seed layer between the metal within the opening and the sidewall of the opening.

Example 4 includes the apparatus of any one of examples 1-3, wherein a dimension of the gap in a direction radial to an elongate axis of the opening is in a range from 25 nanometers (nm) to 250 nm.

Example 5 includes the apparatus of any one of examples 1-4, further including a dielectric layer to cover a first one of the opposing surfaces of the glass layer, the dielectric layer to define an end of the gap.

Example 6 includes the apparatus of any one of examples 1-5, wherein the dielectric layer is a first dielectric layer, further including a second dielectric layer to cover a second one of the opposing surfaces, wherein the gap is an elongate gap extending along the sidewall, the elongate gap having a first end that extends to the first dielectric layer and a second end that extends to the second dielectric layer.

Example 7 includes the apparatus of any one of examples 1-6, further including a layer of material on the sidewall of the opening, the layer of material between the sidewall of the opening and the gap.

Example 8 includes the apparatus of any one of examples 1-7, wherein the layer of material includes parylene.

Example 9 includes the apparatus of any one of examples 1-8, wherein the layer of material has a thickness of less than about 1 micrometer (µm).

Example 10 includes the apparatus of any one of examples 1-9, wherein the layer of material extends at least partially into a cavity in the sidewall of the opening.

Example 11 includes the apparatus of any one of examples 1-10, wherein the gap is a first gap associated with a first position along an elongate axis of the opening, further including a second gap associated with a second position along the elongate axis, the first gap having a first size, the second gap having a second size different from the first size.

Example 12 includes the apparatus of any one of examples 1-11, wherein the first and second gaps are first and second elongate gaps extending along the elongate axis, the first elongate gap having a first length, the second gap having a second length different from the first length.

Example 13 includes the apparatus of any one of examples 1-12, wherein the first and second sizes of the respective first and second gaps are measured in a radial direction extending from the elongate axis of the opening towards the sidewall of the opening, the first gap extending a first distance towards the sidewall, the second gap extending a second distance towards the sidewall, the second distance different from the first distance.

Example 14 includes the apparatus of any one of examples 1-13, wherein at least one of the first or second gaps tapers in size in the radial direction.

Example 15 includes an apparatus comprising a glass core, and a through glass via within a hole extending through the glass core, the through glass via spaced apart from the glass core by a void in a radial direction relative to a longitudinal axis of the through glass via.

Example 16 includes the apparatus of example 15, wherein the void extends a first distance along the radial direction and a second distance along a longitudinal direction of the through glass via, the second distance at least twice the first distance.

Example 17 includes the apparatus of example 15 or example 16, wherein the void is aligned with a defect in the glass core.

Example 18 includes an apparatus comprising a glass core having a first surface, a second surface opposite the first surface, and a first opening extending between the first and second surfaces, the first opening having an inner wall, the inner wall including a second opening, and a conductive material in the first opening, the conductive material separated from the inner wall of the first opening by empty space in the second opening.

Example 19 includes the apparatus of example 18, wherein the second opening fully surrounds a circumference of the conductive material.

Example 20 includes the apparatus of example 18 or example 19, wherein the second opening is adjacent to a void in the glass core, the second opening positioned between the void and the conductive material.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a glass layer having an opening extending between opposing surfaces of the glass layer, the opening having an elongate axis;
a metal within the opening; and
a gap between the metal and a sidewall of the opening.

2. The apparatus of claim 1, wherein the sidewall of the opening is tapered.

3. The apparatus of any one of claims 1-2, wherein there is no metal seed layer between the metal within the opening and the sidewall of the opening.

4. The apparatus of any one of claims 1-3, wherein a dimension of the gap in a direction radial to the elongate axis is in a range from 25 nanometers (nm) to 250 nm.

5. The apparatus of any one of claims 1-4, further including a dielectric layer to cover a first one of the opposing surfaces of the glass layer, the dielectric layer to define an end of the gap.

6. The apparatus of claim 5, wherein the dielectric layer is a first dielectric layer, further including a second dielectric layer to cover a second one of the opposing surfaces, wherein the gap is an elongate gap extending along the sidewall, the elongate gap having a first end that extends to the first dielectric layer and a second end that extends to the second dielectric layer.

7. The apparatus of any one of claims 1-6, further including a layer of material on the sidewall of the opening, the layer of material between the sidewall of the opening and the gap.

8. The apparatus of claim 7, wherein the layer of material includes parylene.

9. The apparatus of claim 7, wherein the layer of material has a thickness of less than about 1 micrometer (µm).

10. The apparatus of claim 7, wherein the layer of material extends at least partially into a cavity in the sidewall of the opening.

11. The apparatus of any one of claims 1-10, wherein the gap is a first gap associated with a first position along the elongate axis of the opening, further including a second gap associated with a second position along the elongate axis, the first gap having a first size, the second gap having a second size different from the first size.

12. The apparatus of claim 11, wherein the first and second gaps are first and second elongate gaps extending along the elongate axis, the first elongate gap having a first length, the second gap having a second length different from the first length.

13. The apparatus of claim 11, wherein the first and second sizes of the respective first and second gaps are measured in a radial direction extending from the elongate axis of the opening towards the sidewall of the opening, the first gap extending a first distance towards the sidewall, the second gap extending a second distance towards the sidewall, the second distance different from the first distance.

14. The apparatus of claim 13, wherein at least one of the first or second gaps tapers in size in the radial direction.

15. An integrated circuit package including the apparatus of any one of claims 1-14.
